# FASCICULE DE BREVET EUROPEEN

(11) **EP 1 287 564 B1**
(45) Date de publication et mention de la délivrance du brevet: **29.03.2006**
(21) Numéro de dépôt: 01931828.6
(22) Date de dépôt: 09.05.2001
(51) Int. Cl.: H01L 29/93

(54) **CONDENSATEUR A CAPACITE VARIABLE**
KONDENSATOR MIT VARIABLER KAPAZITÄT
VARIABLE CAPACITANCE CAPACITOR

(30) Priorité: 09.05.2000 FR 0005887
(43) Date de publication de la demande: 05.03.2003
(73) Titulaire: Centre National De La Recherche Scientifique-CNRS, 75794 Paris Cedex 16 (FR)
(72) Inventeur: SANCHEZ, Jean-Louis, F-31750 Escalquens (FR); LAUR, Jean-Pierre, F-81000 Albi (FR); HAKIM, Hedi, 3041 Merkezchihya (TN); AUSTIN, Patrick, F-31590 Bonrepos-Riquet (FR); JALADE, Jean, F-31320 Castanet-Tolosan (FR); BREIL, Marie, F-31400 Toulouse (FR)
(74) Mandataire: de Beaumont, Michel
(86) Numéro de dépôt international: PCT/FR2001/001401
(87) Numéro de publication internationale: WO 2001/086729

(56) Documents cités:
- DE-A- 1 947 300
- GB-A- 2 305 002
- US-A- 4 017 885
- PATENT ABSTRACTS OF JAPAN vol. 008, no. 119 (E-248), 5 juin 1984 (1984-06-05) & JP 59 033884 A (MATSUSHITA DENSHI KOGYO KK), 23 février 1984 (1984-02-23)

## Description

La présente invention concerne les condensateurs à capacité variable.

Il est connu dans la technique que des condensateurs correspondant par exemple à une jonction polarisée en inverse ont une capacité qui diminue progressivement quand la tension à leurs bornes augmente.

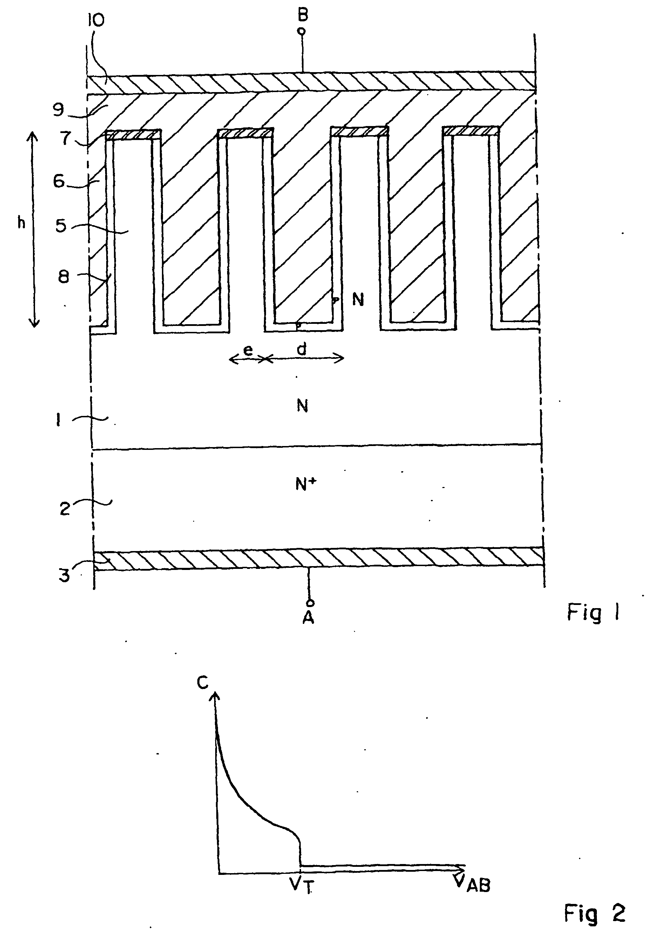

Des condensateurs de ce type sont par exemple décrits dans GB-A 2305002 de Hewlett-Packard, et illustrés en figure 1. Leur courbe capacité/tension est représentée en figure 2.

La figure 1 représente un substrat comprenant une région supérieure 1 de type N et une région inférieure 2 de type N⁺ revêtue d'une métallisation 3 reliée à une borne A. La face supérieure du substrat comporte des parties en relief 5 séparées par des évidements 6. Une région isolante 7 est formée au sommet des reliefs 5. Une région 8 de type P est formée sur les parois latérales des zones en relief 5 ainsi qu'au fond des évidements 6. Une couche conductrice 9 est formée sur toute la face supérieure et est revêtue d'une métallisation 10 reliée à une borne B.

Quand un potentiel positif est appliqué sur la borne A par rapport à la borne B, la jonction PN entre la région 8 et le substrat 1 ou la partie en relief 5 est polarisée en inverse et correspond à un condensateur.

La figure 2 représente l'allure de la capacité C du condensateur ainsi formé quand la tension croît. Pour de faibles valeurs de la tension V_{AB}, la capacité C est sensiblement proportionnelle au périmètre du motif élémentaire du condensateur. En effet, la capacité par unité de surface de la partie supérieure de la structure est peu différente de la capacité par unité de surface d'une jonction du fait que la partie semiconductrice en relief est peu dopée. Tandis que la zone de charge d'espace s'étend, la capacité décroît progressivement puis, au moment où les zones de charge d'espace se rejoignent, on peut considérer que la capacité de la zone en relief est inhibée, c'est-à-dire que sa contribution à la valeur de la capacité disparaît. Pour une valeur seuil V_{T} de la tension, la capacité d'un motif passe alors d'un état où elle est proportionnelle sensiblement au périmètre d'un relief à un état où elle est proportionnelle au pas d'un motif. On obtient donc un condensateur dont la capacité varie progressivement pendant une première phase puis chute pour une tension de seuil V_{T}. Toutefois, comme le montre la figure 2, la plus grande partie de la chute de capacité est progressive, et la partie "commutée" correspond seulement à une petite partie de la variation totale de capacité.

Un objet de la présente invention est de prévoir un condensateur dont la capacité diminue brutalement quand la tension à ses bornes dépasse un seuil prédéterminé.

Pour atteindre cet objet, la présente invention prévoit un condensateur à capacité variable comprenant une structure périodique de zones en relief séparées par des évidements formés dans un substrat semiconducteur d'un premier type de dopage, dans lequel les parois des zones en relief et le fond des évidements sont revêtus d'une couche conductrice, le substrat étant relié à une première borne du condensateur et la couche conductrice à une deuxième borne du condensateur, dans lequel au moins le fond des évidements ou le côté des zones en relief comporte des régions du deuxième type de dopage, le pas des parties en relief étant choisi pour que les zones de charge d'espace liées aux régions du deuxième type de dopage se rejoignent quand la différence de tension entre lesdites bornes dépasse un seuil déterminé. Les zones ne comportant pas les régions du deuxième type de dopage sont revêtues d'un isolant et une région fortement dopée du type de conductivité du substrat est formée sous l'isolant.

Selon un mode de réalisation de la présente invention, la couche conductrice comprend une couche de silicium polycristallin du deuxième type de dopage revêtue d'une métallisation.

Selon un mode de réalisation de la présente invention, les zones en relief forment des nervures.

Selon un mode de réalisation de la présente invention, les zones en relief et les évidements forment une structure multicellulaire.

Selon un mode de réalisation de la présente invention, le fond des évidements ainsi que les parois latérales des zones en relief comportent une région du deuxième type de dopage -

Selon un mode de réalisation, de la présente invention, le fond des évidements comporte une région du deuxième type de dopage tandis que les parois latérales et la partie supérieure de chaque zone en relief sont revêtues d'une couche diélectrique, les zones en relief étant fortement dopées.

La présente invention vise aussi une utilisation du condensateur susmentionné dans un circuit susceptible de présenter aux bornes du condensateur une valeur supérieure ou inférieure à ladite tension de seuil.

Selon un mode de réalisation de la présente invention, le condensateur comprend en périphérie un mur d'isolement fortement dopé du deuxième type de conductivité s'étendant de la face supérieure à la face inférieure du substrat, connecté à ladite couche conductrice et éloigné de la limite de la métallisation de face inférieure d'une distance suffisante pour tenir une tension souhaitée.

Selon un mode de réalisation de la présente invention, du côté de la face inférieure du substrat, une couche d'oxyde de silicium est déposée à la périphérie du composant au-delà de la métallisation de face inférieure.

La présente invention vise aussi l'utilisation du condensateur susmentionné dans un circuit susceptible de présenter aux bornes du condensateur une valeur supérieure ou inférieure à ladite tension seuil.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
la figure 1. décrite précédemment, est une vue en coupe schématique d'un condensateur à capacité variable selon l'art antérieur ;
la figure 2, décrite précédemment, représente la capacité en fonction de la tension du condensateur de la figure 1 ;
la figure 3 représente une vue en coupe schématique d'un premier mode de réalisation d'un condensateur à capacité variable selon la présente invention ;
les figures 4A et 4B sont des vues en perspective partielles illustrant des modes de réalisation d'une partie supérieure de la structure de la figure 3 ;
les figures 5A et 5B représentent une vue en coupe partielle d'un condensateur selon le premier mode de réalisation de la présente invention ;
les figures 6A et 6B représentent respectivement la capacité en fonction de la tension et la charge en fonction de la tension du condensateur des figures 5A et 5B ;
la figure 7 est une vue en coupe partielle d'une variante de réalisation d'un condensateur selon la présente invention ;
les figures 8A et 8B représentent une vue en coupe partielle d'un deuxième mode de réalisation d'un condensateur selon la présente invention ;
les figures 9A et 9B représentent respectivement la capacité en fonction de la tension et la charge en fonction de la tension du condensateur des figures 8A et 8B ; et
la figure 10 représente un mode de réalisation de structure périphérique adaptée à un condensateur selon la présente invention.

Comme cela est d'usage dans le domaine de la représentation des composants semiconducteurs, les diverses vues en coupe ne sont pas représentées à l'échelle. Pour déterminer des dimensions possibles, l'homme de l'art se référera à son expérience générale et aux indications particulières données dans la suite de la présente description.

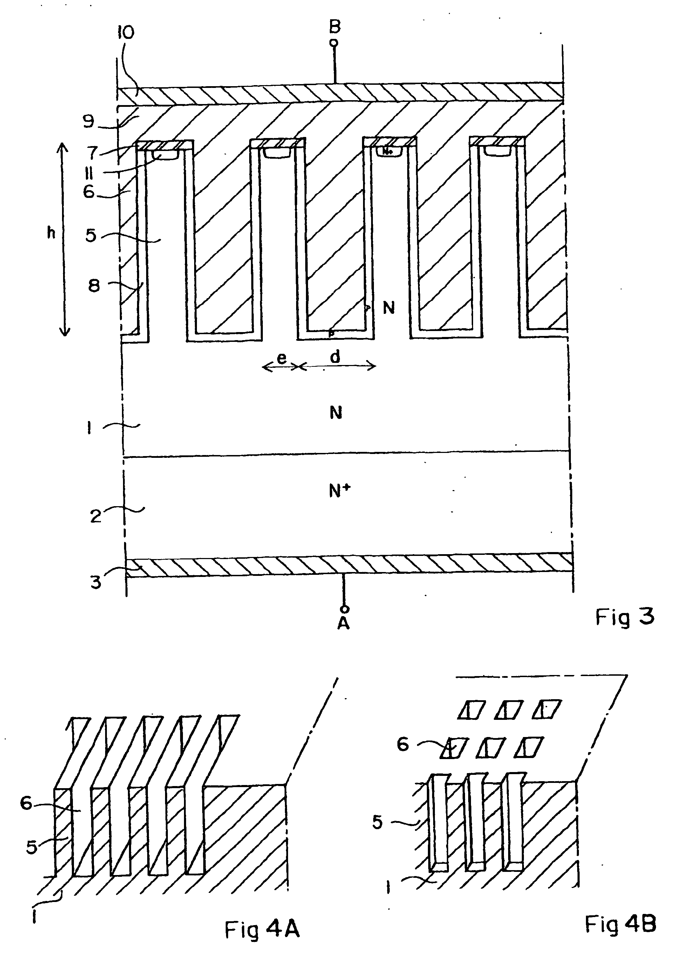

La figure 3 est une vue en coupe partielle d'un condensateur selon un mode de réalisation de la présente invention formé dans une tranche semiconductrice. Ce condensateur est généralement similaire à celui de la figure 1 mais comprend en outre une région fortement dopée de type N sous les portions de couche isolante 7.

Le substrat peut correspondre à une tranche semiconductrice 1 de type N dont la face arrière 2 a subi un dopage à plus forte concentration pour former la région 2, ou bien à une tranche semiconductrice 2 fortement dopée de type N⁺ sur laquelle on a formé une région 1 moins fortement dopée, par exemple par épitaxie.

La couche conductrice 9 est par exemple une couche de silicium polycristallin dopé de type P et est revêtue d'une métallisation 10. Dans le mode de réalisation représenté, la couche conductrice 9 remplit complètement les évidements, mais on comprendra qu'en fonction des dimensions latérales des évidements et de l'épaisseur de cette couche, il y aura ou non remplissage complet des évidements. On désigne par h la hauteur d'une partie en relief, par e sa largeur (ou plus exactement la largeur de la région de type N) et par e+d le pas de la structure.

Les figures 4A et 4B représentent à titre d'exemple, des réalisations possibles des zones en relief 5 et des évidements 6 en l'absence de la couche conductrice 9 et de la métallisation 10. Dans le cas de la figure 4A, les zones en relief correspondent à des nervures 5 séparées par des rainures 6. Dans le cas de la figure 4B, les évidements 6 sont disjoints, de sorte que la structure a une allure de type multicellulaire, chaque évidement ayant par exemple une section triangulaire, carré, rectangulaire, hexagonale... D'autres exemples de structures peuvent être envisagés par l'homme de l'art. Les figures 4A et 4B ont été tracées uniquement pour montrer que la présente invention s'applique à diverses configurations de reliefs et d'évidements.

Dans les figures suivantes, on représentera uniquement une partie en relief encadrée par des évidements. On notera toutefois que ceci s'applique aussi bien à ce qui a été illustré en figure 4A qu'à ce qui a été illustré en figure 4B. D'autre part, par souci de simplicité, on appellera ci-après nervures et rainures les parties en relief et les parties en creux. L' home de l'art notera toutefois que la description ci-après s'applique également à une structure de type multicellulaire telle que celle de la figure 4B. En outre, on considérera ci-après qu'il existe un grand nombre de structures élémentaires de sorte que les effets de bord sont négligeables.

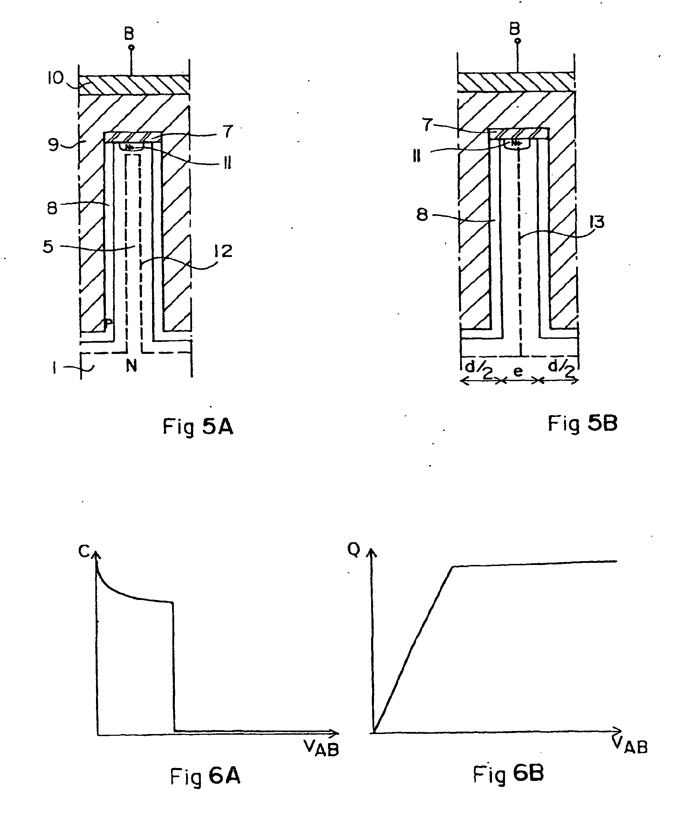

La figure 5A représente à échelle agrandie, une nervure 5 de la figure 3. Les parois de la nervure ainsi que le fond des évidements voisins comportent une région 8 de type P. Cette région P est nettement plus dopée que le substrat N. La région il de type N⁺ ne s'étend de préférence pas jusqu'à la région P pour ne pas réduire la tension de claquage du dispositif. Cette région 11 résulte par exemple d'une implantation. Quand la tension entre les bornes A et B croît dans le sens où la jonction est bloquée, une zone de charge d'espace, représentée en figure 5A comme délimitée par des pointillés 12, s'étend vers l'intérieur par rapport au contour de la région 8 de type P.

En figure 5B, on a représenté la même structure, mais dans le cas où les zones de charge d'espace s'étendant à partir des parois opposées et des régions de fond opposées de la nervure se rejoignent au centre 13 de la nervure.

La figure 6A représente l'allure de la capacité C du condensateur ainsi formé quand la tension croît. Du fait de la présence de la région fortement dopée 11 et du choix d'une faible épaisseur pour l'isolant 7, la capacité diélectrique C1 correspondant à la région isolée 7 est élevée. Ainsi, la capacité totale C du condensateur est plus élevée que dans le cas de la figure 1. Pour de faibles valeurs de la tension V_{AB}, tandis que la zone de charge d'espace s'étend, la capacité C chute à peu près autant que dans le cas de la figure 1 mais seulement pour la partie correspondant à la capacité de jonction C2. Au moment où les zones de charge d'espace se rejoignent conformément à ce qui est représenté en figure 5B, on peut considérer que la nervure est inhibée, c'est-à-dire que la contribution de la capacité C1 à la valeur de la capacité totale C disparaît. La capacité chute alors brutalement, pour une valeur seuil V_{T} de la tension, à une valeur faible. La tension de seuil dépend notamment du niveau de dopage du substrat N et de l'épaisseur de chaque nervure (ou plutôt si l'on se réfère au mode de réalisation de la figure 4B à la distance entre deux évidements adjacents) .

La figure 6B représente la charge Q stockée sur le condensateur en fonction de la tension appliquée V_{AB}. Cette charge croît d'abord relativement rapidement (proportionnellement à la valeur initiale relativement forte de la capacité) puis croit ensuite très lentement (proportionnellement à la valeur relativement faible de la capacité).

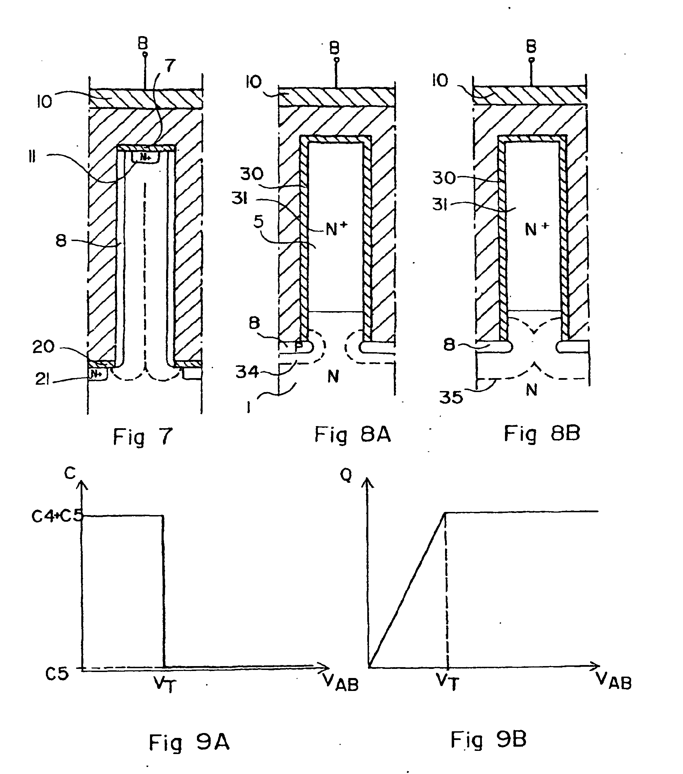

La figure 7 représente une variante de réalisation d'une structure selon la présente invention, et la ligne en pointillés représente l'extension des zones de charge d'espace au moment du basculement de la capacité. Le fond de chaque évidement est revêtu d'un diélectrique 20 sous lequel est formé une région N⁺ 21 et correspond à une capacité diélectrique C3. Si on appelle C1 la capacité diélectrique de la région supérieure et C2 la capacité de jonction des flancs de la nervure, la valeur de la capacité passera de C1+C2+C3 à C3. Le minimum, qui correspond à une capacité diélectrique, a une valeur mieux définie qu'une capacité de jonction.

Les figures 8A et 8B représentent un deuxième mode de réalisation de la présente invention. Dans cette variante, les parois latérales et supérieure de chaque nervure 5 formée dans le substrat 1 sont revêtues d'une couche diélectrique 30, couramnent une couche d'oxyde de silicium, et pratiquement toute la hauteur de la nervure 5 correspond à une région N⁺ 31. La zone 8 de type P est limitée à la paroi inférieure de chaque évidement. En figure 8A, la limite de la zone de charge d'espace est désignée par des traits en pointillés 34. Cette zone de charge d'espace s'étend vers l'intérieur à partir de la zone dopée de type P 8. Dans la configuration illustrée en figure 8B, la tension appliquêe entre les bornes A et B est devenue suffisante pour que les zones de charge d'espace 35 s'étendant à partir de chacune des régions de type P 8 se rejoignent au pied de la nervure 5. Alors, il existe une zone dépeuplée de porteurs entre le substrat et la région de type N constituant la nervure et on peut considérer que le matériau de cette nervure est isolé par rapport au substrat, c'est-à-dire par rapport à la borne A du condensateur.

Au premier ordre, on peut considérer ici que l'on a entre A et B une capacité équivalente à la mise en série d'une capacité diélectrique de valeur C4 ≅ (2h+e)Cₒₓ et d'une capacité liée à une couche dépeuplée de valeur C5 ≅ (e+d)Cₛᵢ.

Alors, la variation de capacité en fonction de la tension appliquée est telle que représentée en figure 9A. Elle a une valeur sensiblement constante C4+C5 tant que la valeur de seuil v_{T} n'a pas été atteinte puis elle chute rapidement à la valeur C5 très faible dès que la tension V_{T} est dépassée.

La figure 9B représente l'allure de la charge stockée Q. Dans un premier temps, elle est égale à C1V, puis, une fois que la tension V_{T} est atteinte, et en supposant que la capacité résiduelle est alors très faible, elle reste sensiblement constante et égale à C1V_{T}.

Le condensateur à capacité variable selon la présente invention pourra être utilisé dans divers circuits dans lesquels on souhaite que, quand la tension aux bornes du condensateur dépasse un seuil prédéterminé, la valeur de la capacité de ce condensateur diminue brutalement. Un exemple d'un tel circuit est celui d'un condensateur d'aide à l'ouverture disposé en parallèle sur un interrupteur statique commandé. Au moment de l'ouverture du transistor, le courant qui circule dans l'interrupteur passe dans le condensateur, ce qui améliore les conditions d'ouverture en diminuant les pertes de commutation. Pour que cette transition se fasse bien, il est souhaitable que le condensateur ait une valeur relativement élevée pendant toute la décroissance du courant. Toutefois, dès que l'interrupteur est ouvert et que la tension à ses bornes s'est mise à croître, il est souhaitable de ne pas augmenter la charge stockée dans le condensateur. Ainsi, un condensateur à chute brutale de capacité selon la présente invention est particulièrement souhaitable dans de telles applications.

On n'a pas décrit ici de mode de fabrication détaillé des structures selon la présente invention. En effet, l'homme de l'art pourra utiliser divers procédés de gravure anisotrope pour creuser des tranchées ou autres ouvertures relativement profondes, d'une hauteur de l'ordre de 80 à 150 *µ*m dans une plaquette de silicium semiconducteur. D'autre part, on connaît divers types de gravures anisotropes permettant de graver le fond et/ou la surface supérieure d'une nervure sans graver ses parois latérales. Ces techniques de gravure, associées à des techniques de dépôt de silicium polycristallin dopé et de diélectrique, permettront d'obtenir les diverses variantes à parois revêtues de diélectrique ou à parois dopées par un dopant de type opposé à celui du substrat.

On notera également que le condensateur selon la présente invention, dont les électrodes se trouvent de part et d'autre d'une plaquette semiconductrice, se prête bien à faire partie d'une structure monolithique comprenant, outre ce condensateur, au moins un commutateur de puissance de type vertical ou latéral ainsi que d'autres dispositifs actifs ou passifs.

Diverses autres variantes de la présente invention apparaîtront à l'homme de l'art sans sortir du domaine de l'invention tel que défini dans les revendications ci-après. Notamment les types de dopage décrits pourront être inversés.

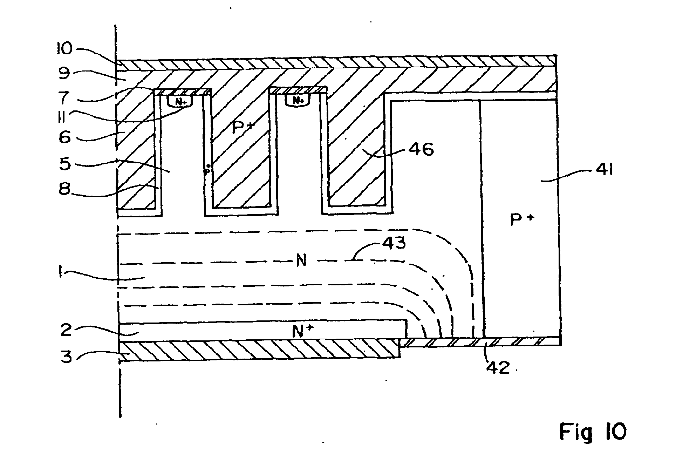

La figure 10 représente un exemple de structure périphérique adaptée à un condensateur selon la présente invention.

Si l'on souhaite qu'un dispositif selon la présente invention tienne une tension élevée, pouvant atteindre plusieurs centaines de volts et même des valeurs pouvant aller jusqu' à 2000 volts, on s'aperçoit que les structures périphériques classiques des composants haute tension verticaux ne conviennent pas. En effet, de façon classique, on prévoit des structures périphériques telles que les équipotentielles s'étalent latéralement et se terminent vers le haut ou vers les bords de la puce. Dans le cas d'un condensateur selon l'invention, étant donné la grande profondeur des rainures formée dans le substrat, des simulations montrent que ces structures périphériques ne conviennent pas car il apparaît une courbure très marquée des équipotentielles au niveau du fond de la plus externe des rainures et on pourra difficilement obtenir des tenues en tensions supérieures à quelques centaines de volts.

Un aspect de la présente invention est de prévoir une structure périphérique adaptée au condensateur selon la présente invention et permettant de tenir de très hautes tensions. Un exemple d'une telle structure périphérique est illustré en figure 10 . La structure est telle que les équipotentielles, au lieu de se refermer vers le haut, comme cela est classique, viennent se refermer vers le bas de la puce.

Dans la partie gauche de la figure 10, on retrouve une structure de condensateur selon l'invention telle qu'illustrée en figure 3, dont les divers éléments sont désignés par les mêmes références.

A la périphérie du composant, comme on le voit du côté du bord droit de la figure 10, la métallisation inférieure 3 est interrompue de même que la région 2 fortement dopée de type N⁺. Le bord de la structure est occupé par un mur d'isolement de type P 41 qui s'étend d'une face à l'autre du composant. Du côté de la face inférieure, une région recouverte d'une couche d'oxyde 42 s'étend entre l'extrémité de la métallisation 3 et la périphérie de la structure, sous la région P⁺ 41 et sous une partie du bord du substrat 1. Ainsi, les lignes équipotentielles, désignées par les références 43 se replient non plus vers la face supérieure du substrat mais vers la face inférieure et ne présentent plus de zone à courbure très élevée. A condition de choisir convenablement la distance entre le mur d'isolement 41 et la limite de la région N⁺ 2 et de la métallisation 3, le composant pourra tenir une tension très élevée, pouvant aller jusqu'à plusieurs milliers de volts. On devra également bien entendu choisir convenablement la distance entre le mur d'isolement 41 et la dernière rainure de condensateur, désignée par la référence 46.

Bien entendu, divers moyens classiques propres à favoriser l'étalement des équipotentielles pourront être adjoints à l'invention. Par exemple, une région P⁻ pourra être prévue au voisinage de la partie inférieure du mur P⁺ 41, des plaques de champ pourront être utilisées...

## Revendications

1. Condensateur à capacité variable comprenant une structure périodique de zones en relief (5) séparées par des évidements (6) formés dans un substrat semiconducteur (1) d'un premier type de dopage, dans lequel les parois des zones en relief et le fond des évidements sont revêtus d'une couche conductrice (9, 10), le substrat étant relié à une première borne (A) du condensateur et la couche conductrice à une deuxième borne (B) du condensateur, dans lequel au moins le fond des évidements ou le côté des zones en relief comporte des régions (8) du deuxième type de dopage, le pas des parties en relief étant choisi pour que les zones de charge d'espace liées aux régions du deuxième type de dopage se rejoignent quand la différence de tension entre lesdites bornes dépasse un seuil déterminé, les zones, ne comportant pas lesdites régions du deuxième type de dopage étant revêtues d'un isolant (7, 20, 30), **caractérisé en ce qu'**une région (11) fortement dopée du type de conductivité du substrat est formée sous l'isolant.

2. Condensateur selon la revendication 1, **caractérisé en ce que** la couche conductrice comprend une couche (9) de silicium polycristallin du deuxième type de dopage revêtue d'une métallisation (10).

3. Condensateur selon la revendication 1, **caractérisé en ce que** les zones en relief forment des nervures.

4. condensateur selon la revendication 1, **caractérisé en ce que** les zones en relief et les évidements forment une structure multicellulaire.

5. condensateur selon la revendication 1, **caractérisé en ce que** le fond des évidements ainsi que les parois latérales des zones en relief comportent une région du deuxième type de dopage (8).

6. Condensateur selon la revendication 1, **caractérisé en ce que** le fond des évidements comporte une région du deuxième type de dopage tandis que les parois latérales et la partie supérieure de chaque zone en relief sont revêtues d'une couche diélectrique (30), les zones en relief étant fortement dopées.

7. Utilisation du condensateur selon l'une quelconque des revendications 1 à 6, dans un circuit susceptible de présenter aux bornes du condensateur une valeur supérieure ou inférieure à ladite tension de seuil.

8. Condensateur selon l'une quelconque des revendications 1 à 6, **caractérisé en ce qu'**il comprend en périphérie, un mur d'isolement (41) fortement dopé du deuxième type de conductivité s'étendant de la face supérieure à la face inférieure du substrat, connecté à ladite couche conductrice (9, 10) et éloigné de la limite de la métallisation de face inférieure (3) d'une distance suffisante pour tenir une tension souhaitée.

9. Condensateur selon la revendication 8, **caractérisé en ce que**, du côté de la face inférieure du substrat, une couche d'oxyde de silicium (42) est déposée à la périphérie du composant au-delà de la métallisation de face inférieure (3).

## Patentansprüche

1. Kondensator mit variabler Kapazität, welcher eine periodische Struktur von Reliefzonen (5) aufweist, die durch in einem Halbleitersubstrat (1) eines ersten Dotierungstyps ausgebildete Ausnehmungen (6) voneinander getrennt sind, in welchem die Wandungen der Reliefzonen und der Boden der Ausnehmungen mit einer leitenden Schicht (9, 10) überzogen sind, wobei das Substrat mit einem ersten Anschluss (A) des Kondensators und die Leiterschicht mit einem zweiten Anschluss (B) des Kondensators verbunden sind, in welchem wenigstens der Boden der Ausnehmungen oder die Seite der Reliefzonen Bereiche (8) des zweiten Dotierungstyps aufweisen und der Gang bzw. die Gitterkonstante der Reliefteile so gewählt ist, dass die mit den Bereichen des zweiten Dotierungstyps verbundenen Raumladungszonen sich berühren, wenn die Spannungsdifferenz zwischen den beiden Anschlüssen einen vorgegebenen Schwellwert übersteigt, wobei die Zonen, welche nicht die Bereiche des zweiten Dotierungstyps enthalten, mit einem Isoliermaterial (7, 20, 30) überzogen sind, **dadurch gekennzeichnet, dass** unterhalb dem Isoliermaterial ein stark dotierter Bereich (11) des Leitfähigkeitstyps des Substrats ausgebildet ist.

2. Kondensator nach Anspruch 1, **dadurch gekennzeichnet, dass** die Leiterschicht eine Schicht (9) aus polykristallinem Silizium vom zweiten Dotierungstyp umfasst, die mit einer Metallisierung (10) versehen ist.

3. Kondensator nach Anspruch 1, **dadurch gekennzeichnet, dass** die Reliefzonen Rippen bilden

4. Kondensator nach Anspruch 1, **dadurch gekennzeichnet, dass** die Reliefzonen und die Ausnehmungen eine vielzellige Struktur bilden.

5. Kondensator nach Anspruch 1, **dadurch gekennzeichnet, dass** der Boden der Ausnehmungen sowie die Seitenwandungen der Reliefzonen einen Bereich (8) des zweiten Dotierungstyps aufweisen.

6. Kondensator nach Anspruch 1, **dadurch gekennzeichnet, dass** der Boden der Ausnehmungen einen Bereich des zweiten Dotierungstyps aufweist, während die Seitenwandungen und der Oberteil jeder Reliefzone mit einer dielektrischen Schicht (30) überzogen sind und die Reliefzonen stark dotiert sind.

7. Anwendung des Kondensators gemäß einem der Ansprüche 1 bis 6 in einen Schaltung, welche an den Anschlüssen des Kondensators einen Betrag größer oder kleiner als die genannte Schwellwertspannung bietet.

8. Kondensator nach einem der Ansprüche 1 bis 6, **dadurch gekennzeichnet, dass** er am Umfang eine stark dotierte Isoliermauer (41) des zweiten Leitfähigkeitstyps aufweist, die sich von der Oberseite zur Unterseite des Substrats erstreckt, mit der genannten Leiterschicht (9, 10) verbunden ist und von der Begrenzung der Metallisierung der Unterseite (3) um einen ausreichenden Abstand entfernt ist, um eine gewünschte Spannung auszuhalten.

9. Kondensator nach Anspruch 8, **dadurch gekennzeichnet, dass** an der Unterseite des Substrats eine Siliziumoxidschicht (42) am Umfang des Bauteils jenseits der Metallisierung der Unterseite (3) abgeschieden ist

## Claims

1. A capacitor with a variable capacitance comprising a periodic structure of areas in relief (5) separated by recesses (6) formed in a semiconductor substrate (1) of a first doping type, in which the walls of the areas in relief and the bottom of the recesses are coated with a conductive layer (9, 10), the substrate being connected to a first terminal (A) of the capacitor and the conductive layer to a second terminal (B) of the capacitor, in which at least the bottom of the recesses or the side of the areas in relief comprises regions (8) of the second doping type, the pitch of the portions in relief being selected so that the space charge areas linked to the regions of the second doping type join when the voltage difference between said terminals exceeds a determined threshold, the areas which do not comprise the regions of the second doping type being coated with an insulator (7, 20, 30), **characterized in that** a heavily-doped region (11) of the conductivity type of the substrate is formed under the insulator.

2. The capacitor of claim 1, **characterized in that** the conductive layer comprises a polysilicon layer (9) of the second doping type coated with a metallization (10).

3. The capacitor of claim 1, **characterized in that** the areas in relief form ribs.

4. The capacitor of claim 1, **characterized in that** the areas in relief and the recesses form a multicellular structure.

5. The capacitor of claim 1, **characterized in that** the bottom of the recesses as well as the lateral walls of the areas in relief comprise a region of the second doping type (8).

6. The capacitor of claim 1, **characterized in that** the bottom of the recesses comprises a region of the second doping type while the lateral walls and the upper part of each area in relief are coated with a dielectric layer (30), the areas in relief being heavily doped.

7. A use of the capacitor of any of claims 1 to 6, in a circuit likely to exhibit across the capacitor a value greater or smaller than said threshold voltage.

8. The capacitor of any of claims 1 to 6, **characterized in that** it comprises at its periphery a heavily-doped isolating wall (41) of the second conductivity type extending from the upper surface to the lower surface of the substrate, connected to said conductive layer (9, 10) and distant from the limit of the lower surface metallization (3) by a distance sufficient to hold a desired voltage.

9. The capacitor of claim 8, **characterized in that**, on the lower surface side of the substrate, a silicon oxide layer (42) is deposited at the component periphery beyond the lower surface metallization (3).
